Europäisches Patentamt

European Patent Office

Office européen des brevets

(11) Publication number: **0 042 158**
**B1**

(12) **EUROPEAN PATENT SPECIFICATION**

(45) Date of publication of patent specification: **12.11.86**

(21) Application number: **81104553.3**

(22) Date of filing: **12.06.81**

(51) Int. Cl.⁴: **H 01 L 31/02, H 04 B 9/00, G 02 B 6/42**

(54) **Optical coupler for transmission and reception over optical fibre.**

(30) Priority: **17.06.80 IT 6793980**

(43) Date of publication of application:
**23.12.81 Bulletin 81/51**

(45) Publication of the grant of the patent:
**12.11.86 Bulletin 86/46**

(84) Designated Contracting States:
**AT BE CH DE FR GB LI NL SE**

(56) References cited:
**GB-A-2 011 610**
**GB-A-2 034 883**
**US-A-4 025 157**

**IBM TECHNICAL DISCLOSURE BULLETIN, vol. 22, no. 1, June 1979, New York, US. J. S. KOLODZEK et al : "Optical connector measurement system", pages 47-48**

**ELECTRONICS INTERNATIONAL, vol. 52, no. 11 May 1979, New York, US. K. SMITH: "High radiance LEDs operate at 1.3um for long-haul optic cable", pages 73-74**

(73) Proprietor: **CSELT Centro Studi e Laboratori Telecomunicazioni S.p.A.**
**Via Guglielmo Reiss Romoli, 274**
**I-10148 Turin (IT)**

(72) Inventor: **Perino, Mauro**
**Via Gamberi, 28 S. Francesco al Campo**
**Torino (IT)**

(74) Representative: **Riederer Freiherr von Paar zu Schönau, Anton et al**
**Freyung 615 Postfach 2664**
**D-8300 Landshut (DE)**

## Description

The invention relates to an optical coupler as defined in the prior art portion of claim 1 for transmitting and receiving over optical fibres.

The main problem to be solved in designing optical couplers is that of introducing a minimum attenuation during the separation of the transmitted light beam from the received one and vice versa. Various methods are known to solve these problems. Systems are known capable of splitting the two beams (received and transmitted beams) by means of specific structures made of optical fibres (Y-shaped couplers) or by means of semitransparent mirrors (beams-splitter). In the German Patent Application No. 25 46 269 published on 21st April, 1977 a system is described, which for splitting the ray transmitted over an optical fibre from the one reflected from the end face of the same, uses a flat mirror placed at 45°, with respect to the fibre axis, and with a central transparent zone.

The light rays, which are to be injected into the fibre, are focused by two cascaded converging optical systems, with their optical axis aligned with the fibre axis; the first of them is placed between the light source and the mirror so as to concentrate the rays emitted by the source in the central transparent zone of the mirror, and the second is placed between the mirror and the fibre end face, so as to concentrate on it the rays emerging from the central transparent zone of the mirror.

The light rays reflected from the optical-fibre end face are collected by said second optical system and projected upon the mirror into a zone wider than the central transparent zone; the rays reflected by the mirror are then focused on a photodetector by a third optical system, placed at 90° with respect to the fibre axis.

The main disadvantage of the system just described resides in the attenuation due to the number of employed optical systems, since each of them attenuates about 1 dB. As both the transmitted and the received rays traverse two cascaded optical systems, each time there is an attenuation of 2 dB, which, taking into account that an attenuation of 3 dB corresponds to a power loss of 50%, is chiefly detrimental to the transmitted ray.

In special applications in which the signals are too low, such attenuation, and consequently such a power loss, becomes unbearable.

In addition, the envisaged system is highly limited by the acceptance angle of the fibre, since with the described system it is impossible to convey into the fibre the light power emitted from the source with an emission angle wider than the acceptance angle typical for the used optical fibre.

In another known system (GB—A 2 011 610), the photodetector has a surface not much larger than the cross section of the optical fibre while the optical emitter and transmission means between the optical emitter and the end face of the optical fibre are made very much smaller so that they do not shadow off too much of the received light. However, this relation of magnitudes cannot generally be adopted, since it demands extremely miniaturized optical emitters and transmission means or high diameter optical fibres.

For injecting light into an optical fibre, it is known to place lenses between the light source and the fibre (IBM Technical Disclosure Bulletin Vol. 22, No. 1, June 1979, pages 47, 48), which fact, however, cannot solve the problems of enhancing the reception efficiency.

It is also known (US—A 4 025 157) to imitate lens functions by a distribution of refractive index graduents in a block of semiconductor material.

The invention intends to provide for the possibility of a coupler design which leads to a high efficiency of the light coupling in both emitting and receiving direction. This is achieved by the invention as characterized in claim 1. The use of the microlens as optical device in the centre of the photodetector allows parallel or converging light rays from the optical device to be sent to the optical fibre so that the size of the optical device may be e.g. in the magnitude of the end face of the optical fibre, without limiting the size of the photodetector which within the cone of the light rays coming from the end face of the optical fibre can be enlarged relative to the size of the microlens upon increasing the distance from the optical fibre end face.

The microlens can advantageously be verified by a cut length of an optical fibre having a refractive index distribution so as to provide for a focusing lens characteristic.

An embodiment of this invention will now be described by way of example, with reference to the accompanying drawings in which:

— Fig. 1 is a schematic perspective view of the optical coupler;

— Fig. 2 is a perspective view of a simplified variant of the coupler;

— Fig. 3 represents an alternative embodiment of the detail denoted by R in Figures 1 and 2.

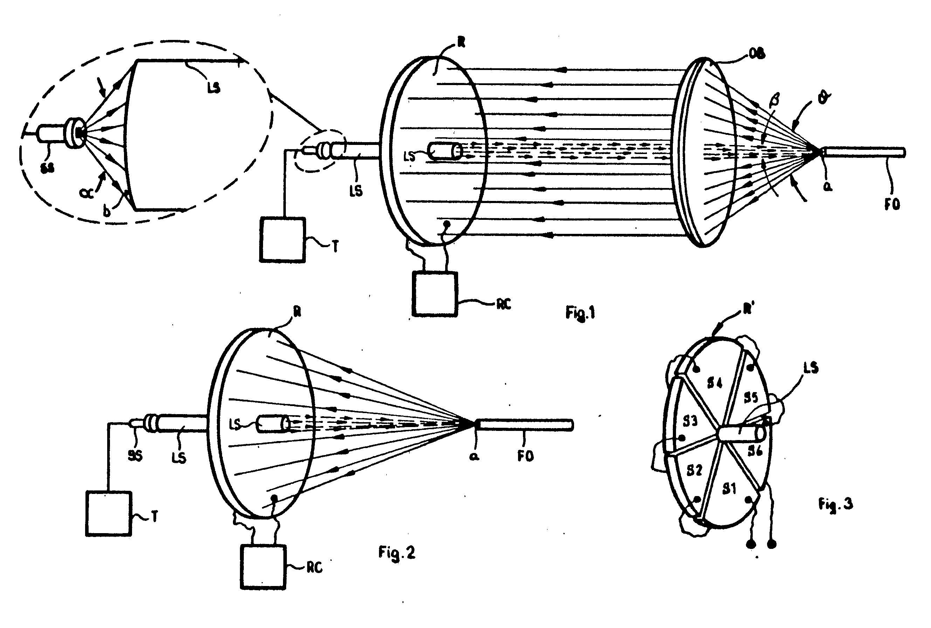

In Fig. 1 reference FO denotes an optical fibre within which contemporaneous transmission and reception of two different optical signals are effected.

Reference "a" denotes the FO end-face, cut according to a plane perpendicular to the fibre axis; the end "a" is placed at the focal point $f_1$ of a usual objective OB.

OB can consist, as known, of a single lens or of a system of lenses and its structure is not prejudiciable to the coupler operation; obviously the choice of the objective kind will be prompted by usual optical considerations.

Reference R denotes a photodetector, with a large, preferably circular, surface which presents in correspondence with the centre a small hole inside which a microlens LS is incorporated; said lens will be examined hereinafter.

The choice of the photodetector obviously depends on the optical signal which is to be detected, and is not critical to the purposes of the present invention.

The plane of R is placed orthogonally to the direction of the parallel rays arriving from objective OB; the distance of R from OB is not critical.

The electrical signal produced by photodetector R is collected and possibly amplified by a receiver RC, whose structure does not concern the present invention.

Microlens LS can be of any known type; in particular in the described example, reference is made to a kind of microlens, generally referred to as SELFOC®, and basically consisting of a segment of calibrated length of optical fibre having a graded index profile and numeral aperture, and consequently acceptance cone $\alpha$, which is sufficiently high.

Microlenses of this type are described in the British Patent No. 1275094.

The end face "b" of LS faces at a distance $f_2$, equal to the microlens focal-length, a light source SS of any type, provided it has an emitting surface small enough to be coupled with a microlens LS.

Practically, as SS operates as an electrooptical transducer of the information deriving from a generic transmitter T, to which SS is connected, photoemitting diodes (LED) or generically lasers, and preferably semiconductor lasers, are used to this aim.

In Fig. 2 references T, RC, R, LS, b, SS, FO, $\alpha$ denote the same parts as in Fig. 1.

Fig. 2 is an alternative embodiment of the device described in Fig. 1 obtained by direct coupling of photodetector R, and corresponding microlens LS, with the optical fibre FO, without the help of objective OB.

In Fig. 3 reference R' indicates a photodetector, analogous to the one indicated by R in Fig. 1, but consisting, for instance, of 6 photodetecting cells S1...S6 which are sector-shaped and connected in series. Reference LS indicates the same microlens as shown in Fig. 1.

The number of S-type sectors into which the surface of photodetector R' is subdivided, can be whatever, their number depending on the required output voltage and on the optical power involved.

The operation of the optical coupler object of the invention, will be described now.

At the receiving side, the light cone $\theta$, coming from the end face "a" of fibre FO, with the aperture depending on the numerical aperture of the used fibre, illuminates the objective OB; since the end face "a" is placed at OB focal point, at OB output a beam of parallel rays will be present, which by illuminating the surface of photodetector R allow the conversion of the optical information into electrical information, which is conveyed to receiver RC.

Obviously in the conversion the part of optical power, falling inside the central zone of the photodetector R, occupied by microlens LS, gets lost.

At the transmitting end the information coming from T is converted by SS into light information.

The optical power emitted by SS, falling within the acceptance angle $\alpha$ of microlens LS, is conveyed by it and emitted in the form of parallel rays towards the objective OB, said rays are focused from OB towards the end face "a" of fibre FO with a solid angle $\beta$, certainly less (smaller) than the acceptance angle $\theta$ typical for the fibre FO.

The attenuation at the receiving side is partly due to that introduced by the objective OB, which is of the order of about 1 dB, and partly to the useless light power which illuminates the end of the microlens LS inserted at the centre of R. The latter part is obviously inversely proportional to the ratio between the areas of photodetector R and of LS section; it decreases while the ratio increases.

In a particular embodiment of the device, object of the invention, this area ratio, consistently with the commercially available components and depending on practical considerations, has been set at 12.5/1, thus obtaining an attenuation of about 0.3 dB.

As a consequence, the overall attenuation, that is attained at the receiving side by the present coupler is of 1.3 dB, which is considerably less than that offered by the devices known in the art.

The attenuation at the transmitting end is basically due to the objective OB since that introduced into microlens LS is, as known, negligible.

The structure of the device depicted in Fig. 1 allows an optimum efficiency level to be reached in the optical coupling between source SS and optical fibre FO.

In fact by duly choosing: a source SS with a sufficiently small emitting area, a microlens LS with sufficiently large numerical aperture with respect to fibre FO, and an optical fibre FO having the "core" section equal at least to the image of said emitting area (as produced by OB on the end face "a" of FO) an optical power, higher than the power that could be injected with the direct coupling of SS with FO, can be injected into the optical fibre FO.

In fact, by acting in this way, the optical power coming from SS in an emission cone $\alpha$ greater than the one of $\theta$, which could be directly accepted by fibre FO, can be utilized.

The consequence is a coupling gain which depends on the ratio of the numerical aperture of microlens LS to the numerical aperture of fibre FO.

In the just described device, photodetector R has been considered as consisting of a single cell, indifferently operating in photoconductive region (that is with inverse polarization) for extracting the received signal or in photovoltaic region (that is without any polarization) when a conversion of optical power into electrical power is required for remote-supply purposes.

In the field of transmission over optical fibre using semiconductor lasers as sources, the optical power concerned is very small, less than 10 mW.

If, for instance, electronic circuits are to be remote power fed a potential difference of the order of some volts is required at the output of the photodetector.

In case of a silicon photodetector one cell is not sufficient because the voltage it can produce under the best conditions is of the order of 0.3 ÷ 0.4 Volts.

In these cases a uniform subdivision (see Fig. 3) of the detector area, in order to obtain a series of cells as equal as possible to one another, to attain the wanted output voltage has proved the most convenient.

The sector disposition has proved the most convenient to ensure the uniform distribution of optical power among the various zones, regardless of whether it derives from an optical fibre with a graded or with a step index profile.

The individual sectors must have as far as possible the same characteristics of voltage-current response, as, since they perform as current generators and are connected in series, they have an overall efficiency determined by the behaviour of the worst of them.

In order to be able to effect the variant depicted in Fig. 2 at the transmitting end source SS has not to be placed at a point at the focal distance $f_2$ of microlens LS, as in the case of Fig. 1, but it has to be stepped back so that the rays emerging from LS may be no longer parallel, but converging and may be directly focused over the face "a" of fibre FO with a solid angle less than θ, provided FO is placed at a suitable distance from LS.

At the receiving side the operation of the device remains unaltered, provided that obviously the surface of detector R is duly illuminated by the cone of light emerging from fibre FO, what can be easily obtained by acting solely on the mutual distance between R and the face "a" of FO.

As the microlens LS is not necessarily integral with photodetector R, but it can move freely inside it is cléar that the two above mentioned adjustments of the distances between "a" and LS and between "a" and R are perfectly compatible.

This last variant obviously allows saving costs of objective OB and the relevant additional attenuation.

In particular, at the receiving side the only attenuation is that depending on the already examined ratio, of the areas of the photodetector R and of the section of microlens LS, for an average value of about 0.3 dB.

At the transmitting end, due to the elimination of OB (Fig. 1), there is only the attenuation introduced by microlens LS, which, as known, is negligible, while the gain due to the ratio of the numerical apertures of the microlens LS to fibre FO slightly decreases due to the increasing distance of source SS from the focal point of LS.

By exploiting the aperture of the light cone emerging from FO the size of the source of photodetector R can be increased so that it ameliorates the ratio of the area of said surface to the area of the section of microlens LS.

In this way higher power is available for instance for power feeding purposes.

If the power received from fibre FO is of the same order of magnitude as the power emitted by SS and reflected by the various optical surfaces, noises may occur, as well known between the transmitted and received signal.

In this case the wavelength of the transmitted light signal ought to be different from that of the received signal and therefore the coupler ought to be made selective.

In this case it is sufficient to apply a normal interferential filter, not represented in the drawing, which covers the active surface of photodetector R, disengaging the surface occupied by microlens LS, in order to transform the described optical coupler from non-selective to selective.

## Claims

1. Optical coupler for coupling an optical fibre (FO) both to a light source (SS) emitting light according to an electrical input signal, and to a light receiver converting the incident light into an electrical output signal, said light receiver comprising a photodetector (R) which presents a light-incident surface and in the centre thereof a hole wherein an optical device having a cross section much smaller than the light-incident surface of the photodetector is placed, at the back-side of which optical device the light source is located, said optical device guiding the light coming from the light source into the end face (a) of the optical fibre which is arranged opposite to the light-incident surface of the photodetector, characterized in that the optical device is a focusing microlens (LS) emitting parallel or converging light rays.

2. Optical coupler as in claim 1, characterized in that the relative position of said microlens (LS) and said photodetector (R), the distance between said microlens (LS) and said source (SS) and the distance between said photodetector (R) and said end face (a) of said optical fibre (FO) can be varied so that the optical power transferred from said source (SS) to said optical fibre (FO) and from said optical fibre to said photodetector (R) is as great as possible.

3. Optical coupler as in claims 1 or 2, characterized in that said photodetector (R) is illuminated by parallel light rays arriving from an objective (OB) at whose focal distance, at the opposite side with respect to that of said photodetector (R), said end face (a) of said optical fibre (FO) is placed and in that said light source (SS) is placed at the focal distance of said microlens (LS) therefrom, and in that said light rays emerge parallel from said microlens (LS), are focused by said objective (OB) and injected, through said end face (a), into said fibre (FO).

4. Optical coupler as in any of claims 1 to 3, characterized in that said photodetector (R) consists of a number of cells (S1...S6) with radial symmetry, which are electrically connected in series.

5. Optical coupler as in any of claims 1 to 4, characterized in that said microlens (LS) is free to axially move in the central hole of that photodetector (R) into which it is introduced.

6. Optical coupler as in any of claims 1 to 5, characterized in that said microlens (LS) consists of a cut-down size of optical fibre with a refractive index gradually varying along the radial direction.

**Patentansprüche**

1. Optischer Koppler zum Koppeln einer Lichtleitfaser (FO) sowohl mit einer Lichtquelle (SS), die Licht entsprechend einem elektrischen Eingangssignal emittiert, als auch mit einem Lichtempfänger, der einfallendes Licht in ein elektrisches Ausgangssignal umwandelt und der einen Photodetektor (R) umfaßt, welcher eine Lichtauftrefffläche und in deren Mitte ein Loch aufweist, in dem eine optische Vorrichtung mit einem Querschnitt, der viel kleiner ist als die Lichtauftrefffläche des Photodetektors, angeordnet ist, wobei sich an der Rückseite der optischen Vorrichtung die Lichtquelle befindet und die optische Vorrichtung das von der Lichtquelle kommende Licht in die Endfläche (a) der Lichtleitfaser einleitet, die gegenüber der Lichtauftrefffläche des Photodetektors angeordnet ist, dadurch gekennzeichnet, daß die optische Vorrichtung ein fokussierende Mikrolinse (LS) ist, die parallele oder konvergierende Lichtstrahlen emittiert.

2. Optischer Koppler nach Anspruch 1, dadurch gekennzeichnet, daß die relative Lage der Mikrolinse (LS) und des Photodetektors (R), der Abstand zwischen der Mikrolinse (LS) und der Lichtquelle (SS) und der Abstand zwischen dem Photodetektor (R) und der Endfläche (a) der Lichtleitfaser (FO) zur Maximierung der von der Lichtquelle (SS) zur Lichtleitfaser (FO) und von der Lichtleitfaser zum Photodetektor (R) übertragenen optischen Leistung veränderlich sind.

3. Optischer Koppler nach Anspruch 1 oder 2, dadurch gekennzeichnet, daß der Photodetektor (R) durch parallele Lichtstrahlen beleuchtet ist, die von einem Objektiv (OB) kommen, fon dem im Abstand seiner Brennweite an der in Bezug zum Photodetektor (R) gegenüberliegenden Seite die Endfläche (a) der Lichtleitfaser (FO) angeordnet ist, und daß die Lichtquelle (SS) im Abstand der Brennweite der Mikrolinse (LS) von dieser angeordnet ist und die Lichtstrahlen von der Mikrolinse (LS) parallel ausgehen, durch das Objektiv (OB) fokussiert werden und durch die Endfläche (a) in die Faser (FO) eingeleitet werden.

4. Optischer Koppler nach einem der Ansprüche 1 bis 3, dadurch gekennzeichnet, daß der Photodetektor (R) aus einer Anzahl von Zellen (S1,..., S6) mit radialer Symmetrie besteht, die elektrisch in Reihe geschaltet sind.

5. Optischer Koppler nach einem der Ansprüche 1 bis 4, dadurch gekennzeichnet, daß die Mikrolinse (LS) im zentralen Loch des Photodetektors (R), in das sie eingesetzt ist, axial beweglich ist.

6. Optischer Koppler nach einem der Ansprüche 1 bis 5, dadurch gekennzeichnet, daß die Mikrolinse (LS) aus einem Längenabschnitt einer Lichtleitfaser mit einem Brechungsindex, der sich entlang der radialen Richtung stetig ändert, besteht.

**Revendications**

1. Coupleur optique pour coupler une fibre optique (FO) à une source lumineuse (SS), qui émet de la lumière en conséquence d'un signal électrique d'entrée et à un récepteur de lumière apte à convertir la lumière incidente en un signal électrique de sortie, ledit récepteur de lumière comprenant un photodétecteur (R) qui présente une surface photosensible et, en correspondance avec son centre, un trou dans lequel on a inséré un dispositif optique dont la coupe est bien plus petite que la surface photosensible du photodétecteur, la source lumineuse étant insérée dans la partie postérieure dudit dispositif optique, ledit dispositif optique guidant la lumière provenant de la source dans l'extrémité (a) de la fibre optique qui est située en face de la surface photosensible du photodétecteur, caractérisé en ce que le dispositif optique est constitué par une microlentille (LS) pour focaliser et émettre des rayons lumineux parallèles ou convergents.

2. Coupleur optique suivant la revendication 1, caractérisé en ce que l'on peut varier: la position relative entre ladite microlentille (LS) et ledit photodétecteur (R), la distance entre ladite microlentille (LS) et ladite source (SS) et la distance entre ledit photodétecteur (R) et l'extrémité (a) de ladite fibre optique (FO), de façon que la puissance optique transférée de ladite source (SS) à ladite fibre optique (FO) et de la fibre optique elle-même au photodétecteur (R) soit la plus grande possible.

3. Coupleur optique suivant les revendication 1 ou 2, caractérisé en ce que ledit photodétecteur (R) est illuminé par des rayons lumineux parallèles provenant d'un objectif (OB) à la distance focale duquel, du côté opposé par rapport à celle de ce photodétecteur (R), on a placé l'extrémité (a) de ladite fibre optique (FO), et en ce qu' à la distance focale de ladite microlentille (LS) on a placé ladite source lumineuse (SS) et en ce que les rayons lumineux qui sortent parallèles de ladite microlentille (LS) sont focalisés par ledit objectif (OB) et injectés, à travers ladite extrémité (a), dans ladite fibre (FO).

4. Coupleur optique suivant une quelconque des revendications 1 à 3, caractérisé en ce que ledit photodétecteur (R) est constitué par un certain nombre de cellules (S1...S6) à symétrie radiale connectées électriquement en série.

5. Coupleur optique suivant une quelconque des revendications 1 à 4, caractérisé en ce que ladite microlentille (LS) est libre de glisser en direction axiale dans le trou central dudit photodétecteur (R) où elle a été introduite.

6. Coupleur optique suivant une quelconque des revendications 1 à 5, caractérisé en ce que ladite microlentille (LS) est constituée par un tronçon de fibre optique ayant un indice de réfraction graduellement variable en sens radial.

Fig.1

Fig.2

Fig.3